(19) Europäisches Patentamt / European Patent Office / Office européen des brevets

(11) **EP 4 318 603 A1**

(12) **EUROPEAN PATENT APPLICATION**
published in accordance with Art. 153(4) EPC

(43) Date of publication:
**07.02.2024 Bulletin 2024/06**

(21) Application number: **22780943.1**

(22) Date of filing: **29.03.2022**

(51) International Patent Classification (IPC):
**H01L 31/041** (2014.01)    **H01L 31/0216** (2014.01)

(52) Cooperative Patent Classification (CPC):
**H01L 31/0216; H01L 31/041**

(86) International application number:
**PCT/JP2022/015546**

(87) International publication number:
**WO 2022/210732 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.03.2021   JP 2021057856**

(71) Applicant: **Idemitsu Kosan Co., Ltd
Tokyo 100-8321 (JP)**

(72) Inventors:
• **HORIGUCHI, Kyohei
Tokyo 100-8321 (JP)**
• **KITAMURA, Yuma
Tokyo 100-8321 (JP)**

(74) Representative: **Hoffmann Eitle
Patent- und Rechtsanwälte PartmbB
Arabellastraße 30
81925 München (DE)**

(54) **PHOTOELECTRIC CONVERSION ELEMENT AND METHOD FOR PRODUCING PHOTOELECTRIC CONVERSION ELEMENT**

(57)    A photoelectric conversion element includes a photoelectric conversion portion, and a proton beam shielding layer that is formed on the photoelectric conversion portion and shields the photoelectric conversion portion from a proton beam. A product of an electron density and a film thickness of the proton beam shielding layer is $5 \times 10^{20}$ (cm$^{-2}$) or more.

FIG. 1

**Description**

Technical Field

The present invention relates to a photoelectric conversion element and a method for manufacturing a photoelectric conversion element.

Background Art

Conventionally, a solar cell, which is one of photoelectric conversion elements, has been used as a power supply means for a satellite or the like operated in outer space. In a solar cell for space use, it is known that lattice defects are generated in a semiconductor by irradiation with a cosmic ray including a proton beam, and an output thereof is reduced. Therefore, various sealing structures for blocking proton beams have been proposed for a solar cell for space use.

For example, Non Patent Literature 1 discloses a sealing structure of a solar cell for space use using a special cover glass and a resin adhesive.

In addition, for example, Patent Literature 1 discloses that an optical thin film is formed on a surface of a solar cell to improve infrared emissivity in order to enhance heat radiation to outer space by infrared emission.

Citation List

Non Patent Literature

Non Patent Literature 1: Sumio Matsuda "Coverglasses protected solar cells from cosmic rays" New GLASS Vol. 14, No. 4, 1999, P27-30, the New Glass Forum

Patent Literature

Patent Literature 1: JP 4565105 B2

Summary of Invention

Technical Problem

As described above, in the sealing structure of a solar cell for space use using a special cover glass, the cover glass itself is very expensive, and bonding of the cover glass is complicated, so that the cost is high. Moreover, since the solar cell becomes heavy, there is room for improvement in suppressing the loading weight at the time of liftoff.

On the other hand, since the optical thin film of Patent Literature 1 cannot shield a low-energy proton beam, it is difficult to prevent deterioration of the solar cell due to the proton beam.

The present invention has been made in view of the above circumstances, and it is an object to provide a photoelectric conversion element that can suppress deterioration in performance of the element due to a proton beam, is lightweight, and is excellent in cost.

Solution to Problem

A photoelectric conversion element of an aspect of the present invention includes a photoelectric conversion portion, and a proton beam shielding layer that is formed on the photoelectric conversion portion and shields the photoelectric conversion portion from a proton beam. The product of an electron density and a film thickness of the proton beam shielding layer is $5 \times 10^{20}$ (cm$^{-2}$) or more.

Advantageous Effects of Invention

According to an aspect of the present invention, it is possible to provide a photoelectric conversion element that can suppress deterioration in performance of the element due to a proton beam, is lightweight, and is excellent in cost.

Brief Description of Drawings

Fig. 1 is a thickness direction cross-sectional view illustrating a configuration example of a solar cell of the present embodiment.

Fig. 2 is a thickness direction cross-sectional view illustrating another configuration example of a solar cell of the present embodiment.

Fig. 3 is a schematic diagram illustrating an influence of a proton beam in a solar cell.

Fig. 4 is a diagram illustrating a relationship between energy of a proton beam and an amount of fluence corresponding to an operation period of a satellite or the like.

Fig. 5 is a diagram illustrating electron densities and proton beam shielding effects of various materials.

Fig. 6 is a diagram illustrating a simulation result of Example 7.

Fig. 7 is a diagram illustrating a simulation result of Example 7.

Fig. 8 is a diagram illustrating a simulation result of Example 7.

Fig. 9 is a diagram illustrating a simulation result of Example 7.

Fig. 10 is a diagram illustrating a simulation result of Example 7.

Description of Embodiments

Hereinafter, an embodiment will be described with reference to the drawings.

In the embodiment, for the sake of easy description thereof, structures or elements other than a main part of the present invention will be described in a simplified or omitted manner. In addition, in the drawings, the same elements are denoted by the same reference numerals. Note that the shapes, dimensions, and the like of the elements in the drawings are schematically illustrated, and do not indicate actual shapes, dimensions, and the like.

The photoelectric conversion element of the present embodiment is attached to a satellite or the like operated in outer space, and is used in an environment exposed to cosmic rays including proton beams. In the present embodiment, a case of a space solar cell will be described as an example of the photoelectric conversion element.

First, proton beam deterioration and heat radiation in a solar cell for space will be outlined.

<Proton Beam Deterioration of Solar Cell>

In a solar cell for space use, it is known that when a proton beam stops in the vicinity of a photoelectric conversion layer of a solar cell, particularly a pn junction portion, a cell output is significantly reduced. In order to suppress the deterioration of the solar cell due to the proton beam, it is sufficient if a solar cell resistant to the deterioration of the proton beam is adopted or the proton beam shielding region is increased in the thickness direction of the element to a level at which the total proton beam amount stopping in the vicinity of the pn junction portion of the solar cell does not affect the maintenance rate of the solar cell. The proton beam shielding region can be increased, for example, by thickening the cover glass.

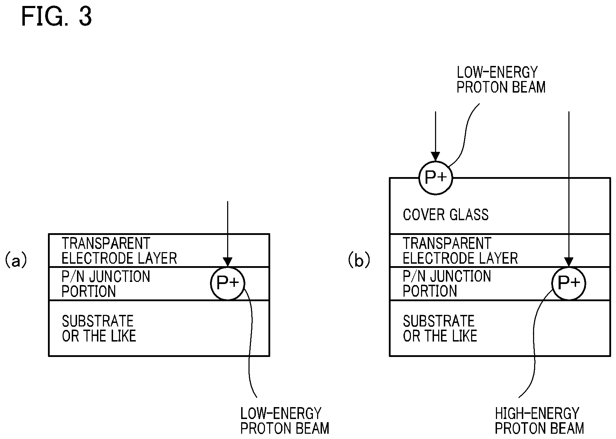

Fig. 3(a) is a schematic diagram illustrating an influence of a proton beam in a solar cell without a shielding region of a cover glass. Fig. 3(b) is a schematic diagram illustrating an influence of a proton beam in a solar cell with a shielding region of a cover glass.

As illustrated in Fig. 3(a), when the solar cell without the shielding region of the cover glass is exposed to cosmic rays, a low-energy proton beam (for example, a proton beam of about 0.2 MeV) stops in the vicinity of, for example, a pn junction portion of the solar cell. On the other hand, as illustrated in Fig. 3(b), when the solar cell with the shielding region of the cover glass (thickness: 100 um) is exposed to cosmic rays, a low-energy proton beam stops in the cover glass, but a higher-energy proton beam (for example, a proton beam of about 3 MeV) passes through the cover glass and stops in the vicinity of, for example, a pn junction portion of the solar cell.

In both of Figs. 3(a) and 3(b), damage given to the pn junction portion of the cell by one proton is substantially the same. However, since the total amount of the high-energy proton beam is smaller than that of the low-energy proton beam, deterioration due to the proton beam is reduced in the case of having the shielding region as illustrated in Fig. 3(b) as compared with Fig. 3(a). However, thickening the cover glass to increase the shielding region leads to an increase in the loading weight.

Here, the integrated emission amount of the proton beam is referred to as fluence (cm$^{-2}$).

When the energy stopped in the photoelectric conversion layer of the solar cell, for example, in the pn junction portion, receives a certain fluence depending on the type of the solar cell, a defect is generated in the pn junction portion, and the lifetime of minority carriers is reduced, so that the electrical characteristics of the solar cell are deteriorated.

Regarding GaAs solar cells and CIGS solar cells, the fluence with respect to a certain energy and the maintenance rate of electrical characteristics have been reported in various documents. According to the reports of these documents, it can be said that when the fluence is less than $1 \times 10^{10}$ (cm$^{-2}$), the maintenance rate of the electrical characteristics of the solar cell is sufficiently high, and deterioration of the solar cell is small.

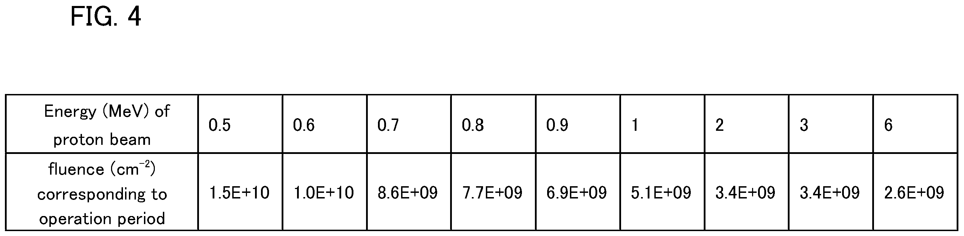

In addition, Fig. 4 illustrates a relationship between energy of a proton beam and an amount of fluence corresponding to the operation period of a satellite or the like calculated on the basis of a representative outer space radiation environment model (NASA AP8 model).

As described above, in order to suppress the deterioration of the solar cell due to the proton beam, the fluence corresponding to the operation period of the satellite or the like is required to be less than $1 \times 10^{10}$ (cm$^{-2}$). It can be seen from Fig. 4 that when the energy of the proton beam is larger than 0.6 MeV, the fluence corresponding to the operation period of the satellite or the like can be made lower than $1 \times 10^{10}$ (cm$^{-2}$). Accordingly, the proton beam shielding region is required to have performance of blocking a proton beam of 0.6 MeV or less.

Next, a method for calculating the shielding of the proton beam will be described.

When a certain substance is irradiated with a proton beam, the proton passes through the substance while losing energy. The amount of energy the proton loses at this time is referred to as stopping power. The stopping power S (E) can be calculated by, for example, simulation software called Stopping Range of Irons in Solid (http://www.srim.org/). In addition, a distance until the proton loses energy with respect to the stopping power S (E) and stops is referred to as a range X. The range X is equal to a value obtained by integrating the reciprocal of the stopping power S (E) with energy E until the proton stops as indicated in Formula (1).

[Math. 1]

$$X = \int_0^E \frac{1}{S(E)} \, dE \quad (1)$$

By the range X calculated by Formula (1), the thickness (that is, the film thickness capable of shielding the proton beam) of an arbitrary material when the proton beam of certain energy is stopped in the coating of the material can be calculated.

In addition, the stopping power is correlated with electron density n of the material indicated by Formula (2). Here, $N_A$ is the Avogadro constant and Z is the average atomic number of the material. In addition, $\rho$ is the density of the material, and A is the average mass number of the material.

[Math. 2]

$$n = \frac{N_A \cdot Z \cdot \rho}{A} \quad (2)$$

As described above, the energy of protons to be shielded can be expressed by the product of the electron density and the film thickness of the material.

<Heat Radiation of Solar Cell in Outer Space>

In general, a semiconductor such as a solar cell needs to be cooled because performance deterioration and life deterioration occur in a state where high heat is applied. Unlike the ground, there is no atmosphere in space, and solar cells in space are in a vacuum insulation state. Accordingly, since solar cells in space cannot exchange heat with the atmosphere, cooling is performed mainly by infrared emission.

The cooling efficiency by infrared emission is defined by emissivity $\varepsilon$ indicated in Formula (3), and the higher the emissivity, the higher the cooling efficiency of the solar cell.

[Math. 3]

$$\varepsilon(T) = \frac{\int_{2.5}^Y \{1 - R\} \cdot U(\lambda, T) d\lambda}{\int_{2.5}^Y U(\lambda, T) d\lambda} \quad (3)$$

Here, R is the reflectance, U is the radiation intensity of the black body, T is the temperature (K), and $\lambda$ is the wavelength (pm). Note that since a substrate including a metal film such as a solar cell does not transmit light, the transmittance is set to 0. The emissivity at an arbitrary temperature T can be calculated from Formula (3). In the embodiment and examples, as an example, the emissivity is calculated from room temperature.

The denominator of Formula (3) indicates the radiation intensity of the black body. The numerator of Formula (3) is obtained by multiplying the radiation intensity of the black body by (1-R). Then, the size of the numerator with respect to the denominator of Formula (3) corresponds to the emissivity ε. Accordingly, it can be understood that in order to increase the emissivity ε, it is only required to decrease the reflectance R and increase the value of the numerator of Formula (3).

The range of wavelengths to be integrated is 2.5 um to Y μm, and Y is arbitrarily selected depending on the use environment. In the embodiment and the examples, as an example, the emissivity ε is calculated in a wavelength range from wavelength 2.5 um to 25 um. Note that the emissivity may be calculated from a wavelength range from wavelength 2.5 um to 35 um, which is a wider wavelength range.

For example, the reflectance R of the substrate on which a single-layer thin film is formed is calculated as described below from the formula of Fresnel thin film interference.

[Math. 4]

$$R = \left| \frac{r_1 + r_s exp(-i\varphi_1)}{1 + r_1 r_s exp(-i\varphi_1)} \right|^2$$

$$\varphi_1(\lambda, n_1, k_1) = \frac{4\pi d_1}{\lambda}(n_1 - k_1 i)$$

In case of normal incidence, according to Snell's law,

$$r_1(\lambda, n, k) = \frac{N_a - N_1}{N_a + N_1} = \frac{(n_a - n_1) - (k_a - k_1)i}{(n_a + n_1) - (k_a + k_1)i}$$

$$r_s(\lambda, n, k) = \frac{N_1 - N_s}{N_1 + N_s} = \frac{(n_1 - n_s) - (k_1 - k_s)i}{(n_1 + n_s) - (k_1 + k_s)i}$$

Here, $N_a$ is a complex refractive index outside (vacuum) the light receiving surface, $N_\alpha$ is a complex refractive index of a thin film α, and $N_s$ is a complex refractive index of the substrate. $d_\alpha$ is the film thickness of the thin film α, and $\varphi_\alpha$ is the optical path difference of the thin film α. In addition, n is a refractive index (real part of complex refractive index), and k is an extinction coefficient (imaginary part of complex refractive index). Note that when the thin film is a single layer, a variable α is 1.

In addition, for example, the reflectance R of the substrate on which three-layer thin films are formed is calculated by the formula described below. Here, the thin film on the substrate side is referred to as thin film 1 (α = 1), the thin film facing the thin film 1 is referred to as thin film 2 (α = 2), and the thin film on the light receiving surface side facing the thin film 2 is referred to as thin film 3 (α = 3).

[Math. 5]

$$R = \left| \frac{r_3 + \left( \dfrac{r_2 + \left( \dfrac{r_1 + r_s exp(-i\varphi_1)}{1 + r_1 r_s exp(-i\varphi_1)} \right) exp(-i\varphi_2)}{1 + r_2 \left( \dfrac{r_1 + r_s exp(-i\varphi_1)}{1 + r_1 r_s exp(-i\varphi_1)} \right) exp(-i\varphi_2)} \right) exp(-i\varphi_3)}{1 + r_3 \left( \dfrac{r_2 + \left( \dfrac{r_1 + r_s exp(-i\varphi_1)}{1 + r_1 r_s exp(-i\varphi_1)} \right) exp(-i\varphi_2)}{1 + r_2 \left( \dfrac{r_1 + r_s exp(-i\varphi_1)}{1 + r_1 r_s exp(-i\varphi_1)} \right) exp(-i\varphi_2)} \right) exp(-i\varphi_3)} \right|^2$$

According to each of the above formulae, the reflectance R is obtained by the film thickness d of the thin film, and the refractive index n and the extinction coefficient k of the thin film material. In other words, it is possible to obtain a thin film having desired characteristics suitable for heat radiation in a space environment by a combination of the parameters n and k of the thin film material and the film thickness d of the thin film.

<Configuration Example of Solar Cell>

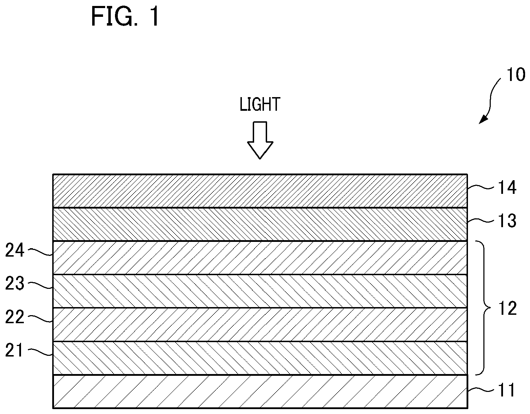

Next, a configuration of a solar cell for space use of the present embodiment will be described with reference to the drawings. Fig. 1 is a thickness direction cross-sectional view illustrating a configuration example of a solar cell of the present embodiment. In the example of Fig. 1, a configuration example of a CIS-based solar cell will be described.

A solar cell 10 has a stacked structure in which a photoelectric conversion portion 12, a proton beam shielding layer 13, and a heat emission layer 14 are sequentially stacked in order from the bottom (substrate side) on a conductive substrate 11. Light such as sunlight enters the photoelectric conversion portion 12 from the side opposite to the conductive substrate 11 side (the upper side in Fig. 1).

(Conductive Substrate 11)

The conductive substrate 11 is formed of, for example, titanium (Ti), stainless steel (SUS), copper, aluminum, an alloy thereof, or the like. The conductive substrate 11 may be a rigid metal substrate or a flexible metal substrate. The conductive substrate 11 may have a stacked structure in which a plurality of metal base materials is stacked, and for example, a stainless foil, a titanium foil, or a molybdenum foil may be formed on the surface of the substrate.

The shape and dimension of the conductive substrate 11 are appropriately determined according to the size and the like of the solar cell 10. The entire shape of the conductive substrate 11 of the present embodiment is, for example, a rectangular flat plate shape, but is not limited thereto.

When a flexible metal substrate is applied as the conductive substrate 11, the solar cell 10 can be bent, and cracking of the substrate due to bending can also be suppressed. Further, in the above case, it is easy to reduce the weight and thickness of the solar cell 10 as compared with a glass substrate and a resin substrate.

Note that, in the solar cell for space use, the conductive substrate 11 is preferably formed of titanium or an alloy containing titanium from the viewpoint of suppressing the loading weight at the time of liftoff and increasing the strength of the solar cell.

(Photoelectric Conversion Portion 12)

The photoelectric conversion portion 12 has a stacked structure in which a first electrode layer 21, a photoelectric conversion layer 22, a buffer layer 23, and a second electrode layer 24 are sequentially stacked in order from the bottom (substrate side).

(First Electrode Layer 21)

The first electrode layer 21 is a metal electrode layer such as of molybdenum (Mo) or the like, and is formed on the conductive substrate 11. The first electrode layer 21 faces not the light receiving surface side but the back surface side (conductive substrate 11 side) of the photoelectric conversion layer 22, and thus is also referred to as a back surface electrode. Although not particularly limited, the thickness of the first electrode layer 21 is, for example, 50 nm to 1000 nm.

(Photoelectric Conversion Layer 22)

The photoelectric conversion layer 22 is formed on the first electrode layer 21. The photoelectric conversion layer 22 may have a double graded structure having a large band gap on the light receiving surface side (upper side in Fig. 1) and the back surface side (lower side in Fig. 1) and a small band gap on the inner side in the thickness direction of the photoelectric conversion layer 22. Although not particularly limited, the thickness of the photoelectric conversion layer 22 is, for example, 1.0 um to 3.0 $\mu$m.

The photoelectric conversion layer 22 functions as a polycrystalline or microcrystalline p-type compound semiconductor layer. The photoelectric conversion layer 22 is, for example, a CIS-based photoelectric conversion element using a group I-III-VI$_2$ compound semiconductor having a chalcopyrite structure containing a group I element, a group III element, and a group VI element (chalcogen element). The group I element can be selected from copper (Cu), silver (Ag), gold (Au), and the like. The group III element can be selected from indium (In), gallium (Ga), aluminum (Al), and the like. In addition, the photoelectric conversion layer 22 may contain tellurium (Te) or the like in addition to selenium (Se) and sulfur (S) as the group VI element. In addition, the photoelectric conversion layer 22 may contain an alkali metal such as Li, Na, K, Rb, or Cs.

(Buffer Layer 23)

The buffer layer 23 is formed on the photoelectric conversion layer 22. Although not particularly limited, the thickness of the buffer layer 23 is, for example, 10 nm to 100 nm.

The buffer layer 23 is, for example, an n-type or i (intrinsic)-type high-resistance conductive layer. Here, the term "high resistance" means having a resistance value higher than the resistance value of the second electrode layer 24 described below.

The buffer layer 23 can be selected from compounds including zinc (Zn), cadmium (Cd), and indium (In). Examples of the compound including zinc include ZnO, ZnS, Zn(OH)$_2$, or Zn(O,S) and Zn(O,S,OH), which are mixed crystals thereof, and further ZnMgO and ZnSnO. Examples of the compound including cadmium include CdS, CdO, or Cd(O,S) and Cd(O,S,OH), which are mixed crystals thereof. Examples of the compound including indium include InS, InO, or In(O,S) and In(O,S,OH), which are mixed crystals thereof, and In$_2$O$_3$, In$_2$S$_3$, In(OH)$_x$, and the like can be used. In addition, the buffer layer 23 may have a stacked structure of these compounds.

Note that the buffer layer 23 has an effect of improving characteristics such as photoelectric conversion efficiency, but this may be omitted. When the buffer layer 23 is omitted, the second electrode layer 24 is formed on the photoelectric conversion layer 22.

(Second Electrode Layer 24)

The second electrode layer 24 is formed on the buffer layer 23. The second electrode layer 24 is, for example, an n-type conductive layer. Although not particularly limited, the thickness of the second electrode layer 24 is, for example, 0.5 um to 2.5 um.

The second electrode layer 24 preferably includes, for example, a material having a wide band gap and a sufficiently low resistance value. In addition, since the second electrode layer 24 serves as a path of light such as sunlight, it is preferable to have a property of transmitting light having a wavelength that can be absorbed by the photoelectric conversion layer 22. From this point of view, the second electrode layer 24 is also referred to as a transparent electrode layer or a window layer.

The second electrode layer 24 includes, for example, a metal oxide to which a group III element (B, Al, Ga, or In) is added as a dopant. Examples of the metal oxide include ZnO and SnO$_2$. The second electrode layer 24 can be selected from, for example, In$_2$O$_3$ (indium oxide), ITO (indium tin oxide), ITiO (indium titanium oxide), IZO (indium zinc oxide), ZTO (zinc tin oxide), FTO (fluorine-doped tin oxide), GZO (gallium-doped zinc oxide), BZO (boron-doped zinc oxide), AZO (aluminum-doped zinc oxide), and the like.

(Proton Beam Shielding Layer 13)

The proton beam shielding layer 13 is an optical thin film formed on the second electrode layer 24 of the photoelectric conversion portion 12, and functions as a shielding region for the proton beam incident from the light receiving surface side.

As a material of the proton beam shielding layer 13, a material having high light transmittance and a refractive index between the photoelectric conversion portion 12 and vacuum is used. As an example, the proton beam shielding layer 13 is formed of a material selected from one or more of $Al_2O_3$, $Y_2O_3$, $ZrO_2$, MgO, $HfO_2$, $Bi_2O_3$, $TiO_2$, ZnO, $In_2O_3$, $SnO_2$, $Nb_2O_5$, and $Ta_2O_5$. Each of the above materials satisfies the conditions of light transmittance and refractive index, and is also excellent in cost.

Note that the proton beam shielding effect depends on the electron density of the material, and does not depend on the bonding state. Therefore, the material of the proton beam shielding layer 13 may be a mixed composition containing any one or more of the above materials.

In the proton beam shielding layer 13 of the present embodiment, the product of the electron density and the film thickness is set to $5 \times 10^{20}$ ($cm^{-2}$) or more in order to shield the proton beam having energy of at least 0.6 MeV or less. Preferably, in the proton beam shielding layer 13, the product of the electron density and the film thickness is set to $1.06 \times 10^{21}$ ($cm^{-2}$) or more in order to shield the proton beam having energy of 1 MeV or less.

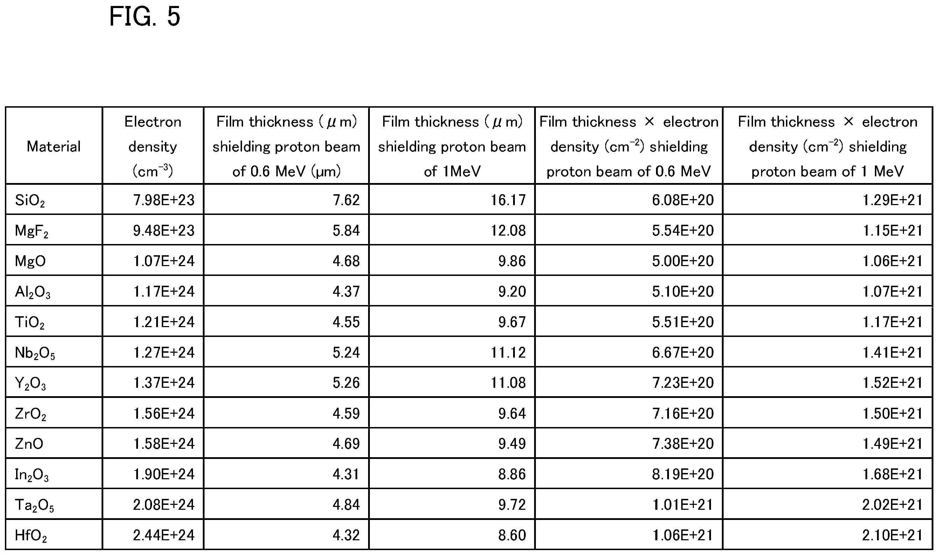

Fig. 5 is a diagram illustrating electron densities and proton beam shielding effects of various materials. In Fig. 5, regarding various materials, the electron densities of the materials, the film thicknesses for shielding proton beams of 0.6 MeV and 1 MeV, and the film thicknesses × electron densities for shielding proton beams of 0.6 MeV and 1 MeV are illustrated. Note that as the materials illustrated in Fig. 5, materials having a refractive index value between the surface of the solar cell and vacuum, high translucency, and excellent cost performance is selected from the viewpoint of film formation on the solar cell.

The energy for stopping the proton beam in the various materials is calculated from the range. As illustrated in Fig. 5, the minimum value of film thickness × electron density in the case of shielding a proton beam of 0.6 MeV is $5 \times 10^{20}$ ($cm^{-2}$) of MgO. Accordingly, it can be seen that it is sufficient if the film thickness × electron density is $5 \times 10^{20}$ ($cm^{-2}$) or more in the case of shielding a proton beam of 0.6 MeV or less.

In addition, it is more preferable that the proton beam shielding layer 13 can shield a proton beam of 1 MeV or less. As illustrated in Fig. 5, the minimum value of film thickness × electron density in the case of shielding a proton beam of 1 MeV is $1.06 \times 10^{21}$ ($cm^{-2}$) of MgO. Accordingly, it can be seen that it is sufficient if the film thickness × electron density is $1.06 \times 10^{21}$ ($cm^{-2}$) or more in the case of shielding a proton beam of 1 MeV or less.

In addition, the larger the film thickness of the proton beam shielding layer 13, the heavier the weight. Here, the electron density × the film thickness of a general cover glass for space use (thickness: 100 um) is $6.68 \times 10^{21}$ ($cm^{-2}$). Therefore, from the viewpoint of making the proton beam shielding layer 13 lighter than the cover glass, the electron density × the film thickness is preferably less than $6.68 \times 10^{21}$ ($cm^{-2}$).

In addition, the proton beam shielding layer 13 may be a multilayered film in which layers of different materials selected from the above materials are stacked. Even in the case of the multilayered film, since the film thickness necessary for shielding the proton beam is calculated from the range, even when the proton beam shielding layer 13 has a plurality of layers, the proton beam shielding effect is not impaired. In addition, from the viewpoint of increasing the infrared emissivity of the solar cell 10, it is preferable to stack materials having different refractive indexes and extinction coefficients also in the proton beam shielding layer 13.

In addition, the thin film stacked on the photoelectric conversion portion 12 ideally has a structure in which the refractive index monotonically increases in the thickness direction from the light receiving surface side to the transparent electrode layer over a wide wavelength range from visible light to infrared light. However, in general, in many cases, the change in the refractive index in the thickness direction does not monotonically increase in any wavelength range, and optical design for bringing the optical performance close to desired optical performance over the entire thin film is performed. At this time, by adjusting the optical performance over the entire thin film by using the proton beam shielding layer 13 as a multilayered film, it is easy to flexibly perform the optical design of the thin film stacked on the photoelectric conversion portion 12.

(Heat Emission Layer 14)

The heat emission layer 14 is an optical thin film formed on the proton beam shielding layer 13, and has a function of promoting cooling by emission of the solar cell 10. Although not particularly limited, the emissivity of the heat emission layer 14 is preferably 0.80 or more in order to efficiently cool the solar cell 10 by infrared emission.

In a case where only the proton beam shielding layer 13 is formed on the photoelectric conversion portion 12, it is difficult to satisfy a desired emissivity, and in a case where the desired emissivity can be satisfied, the film thickness can be very thick. Therefore, by stacking the heat emission layer 14 on the proton beam shielding layer 13, it is possible to ensure a desired emissivity while ensuring the proton beam shielding effect.

Examples of the material used for the heat emission layer 14 include $SiO_2$ or $Al_2O_3$, which is a material having a high emissivity. The heat emission layer 14 may be a single-layer film of either $SiO_2$ or $Al_2O_3$ material, or may be stacked films in which thin films of $SiO_2$ and $Al_2O_3$ are stacked. From the viewpoint of increasing the infrared emissivity of the solar cell 10, it is preferable to stack materials having different refractive indexes and extinction coefficients for the heat emission layer 14.

In addition, the heat emission layer 14 preferably has a film thickness of 210 nm or more in order to have an emissivity of 0.8 or more. In addition, in a case where the heat emission layer 14 is stacked films, in order to have an emissivity of 0.8 or more, the film thickness of any one of film included in the stacked film is preferably 110 nm or more.

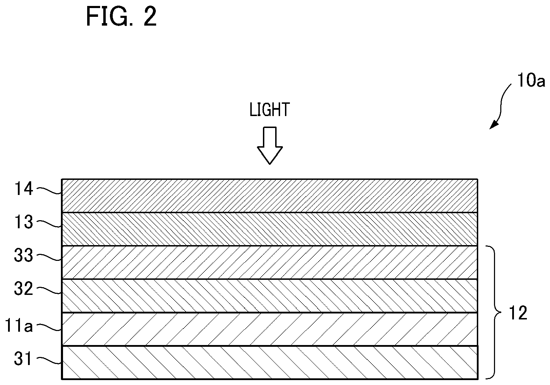

Fig. 2 is a thickness direction cross-sectional view illustrating another configuration example of a solar cell of the present embodiment. In the example of Fig. 2, a configuration example of a solar cell using a crystalline Si-based or GaAs-based semiconductor substrate will be described. Note that, in the example of Fig. 2, the same reference numerals are given to elements common to those in Fig. 1, and redundant description is omitted.

A solar cell 10a illustrated in Fig. 2 has a stacked structure in which a photoelectric conversion portion 12, a proton beam shielding layer 13, and a heat emission layer 14 are sequentially stacked. Light such as sunlight enters the photoelectric conversion portion 12 from the heat emission layer 14 side (the upper side in Fig. 2).

The photoelectric conversion portion 12 includes a first conductivity type semiconductor substrate 11a, a first electrode layer 31, a second conductivity type semiconductor layer 32, and a second electrode layer 33. Here, the first conductivity type is one of p-type and n-type, and the second conductivity type is the other of p-type and n-type.

The semiconductor substrate 11a is, for example, a silicon substrate made of a first conductivity type single crystal or polycrystal. When the first conductivity type is p-type, for example, the semiconductor substrate 11a is configured to be doped with a small amount of a group III element (for example, boron, aluminum, or the like). When the first conductivity type is n-type, for example, the semiconductor substrate 11a is configured to be doped with a small amount of a group V element (for example, phosphorus, arsenic, or the like).

The first electrode layer 31 is a back surface electrode formed on one surface side (lower side in Fig. 2) of the semiconductor substrate 11a. The first electrode layer 31 includes a thin film of a conductive metal such as silver (Ag), aluminum (Al), or titanium (Ti).

The second conductivity type semiconductor layer 32 is, for example, a layer made of crystalline or polycrystalline silicon of the second conductivity type, and constitutes a pn junction with the first conductivity type semiconductor substrate 11a. The semiconductor layer 32 may be provided on the entire other surface side of the semiconductor substrate 11a, or may be provided on a part of the other surface side of the semiconductor substrate 11a. In addition, when the second conductivity type is n-type, for example, the semiconductor layer 32 is configured to be doped with a small amount of a group V element (for example, phosphorus, arsenic, or the like). When the second conductivity type is p-type, for example, the semiconductor layer 32 is configured to be doped with a small amount of a group III element (for example, boron, aluminum, or the like).

The second electrode layer 33 is formed on the semiconductor layer 32. The second electrode layer 33 is configured as, for example, a transparent electrode layer having translucency or a comb-shaped bus bar electrode.

The proton beam shielding layer 13 illustrated in Fig. 2 is formed on the second electrode layer 33, and the heat emission layer 14 is formed on the proton beam shielding layer 13. The proton beam shielding layer 13 and the heat emission layer 14 are similar to the configuration of Fig. 1.

<Method for Manufacturing Solar Cell>

Next, a method for manufacturing the solar cell of the above embodiment will be described.

A step of forming the photoelectric conversion portion 12 on the conductive substrate 11 within the solar cell 10 illustrated in Fig. 1 is similar to the step of manufacturing a general CIS-based solar cell. That is, the photoelectric conversion layer 22 is formed by forming a precursor layer on the surface of the conductive substrate 11 on which the first electrode layer 21 is formed and chalcogenizing the precursor layer. Then, the buffer layer 23 and the second electrode layer 24 are sequentially stacked on the photoelectric conversion layer 22 to form the photoelectric conversion portion 12.

On the other hand, in the case of the solar cell 10a illustrated in Fig. 2, the photoelectric conversion portion 12 is formed by forming the first electrode layer 31 on one surface side of the semiconductor substrate 11a and forming the semiconductor layer 32 and the second electrode layer 33 on the other surface side of the semiconductor substrate 11a by a general process of forming a semiconductor layer or an electrode layer.

Next, the proton beam shielding layer 13 and the heat emission layer 14 are sequentially formed on the second electrode layer 24 (or the second electrode layer 33) of the photoelectric conversion portion 12. The proton beam shielding layer 13 and the heat emission layer 14 are each formed by using a semiconductor thin film forming process such as a sputtering method, a chemical vapor deposition (CVD) method, a vapor deposition method, a metal organic deposition (Mod) method, or an aerosol deposition (AD) method. Note that the total film thickness of the proton beam shielding layer 13 and the heat emission layer 14 is, for example, in a range of 1 um to 65 $\mu$m.

As an example, an example of film formation conditions in a case where a $Y_2O_3$ thin film and an $Al_2O_3$ thin film are formed as the proton beam shielding layer 13 and $SiO_2$ is formed as the heat emission layer 14 is indicated in Table 1 below. In the example described below, the thin films of the proton beam shielding layer 13 and the heat emission layer 14 are formed by electron beam evaporation.

[Table 1]

| Material | Emission (mA) | SWEEP X,Y | rate (nm/s) | Pressure (Pa) |
|---|---|---|---|---|
| $SiO_2$ | 36 | 10 | 0.42 | $2\times10^{-3}$ |
| $Al_2O_3$ | 95 | 10 | 0.35 | $2\times10^{-3}$ |
| $Y_2O_3$ | 120 | 10 | 0.45 | $2\times10^{-3}$ |

As described above, the solar cells 10 and 10a of the present embodiment include the proton beam shielding layer 13 that shields the photoelectric conversion portion 12 from the proton beam on the second electrode layer 24 (or the second electrode layer 33) of the photoelectric conversion portion 12. The product of the electron density and the film thickness of the proton beam shielding layer 13 is $5 \times 10^{20}$ (cm$^{-2}$) or more.

As a result, in the solar cells 10 and 10a of the present embodiment, the proton beam shielding layer 13 can shield a proton beam of 0.6 MeV or less, and the fluence corresponding to the operation period of the satellite or the like can be made lower than $1 \times 10^{10}$ (cm$^{-2}$). Accordingly, according to the present embodiment, it is possible to suppress deterioration in the performance of the element due to the proton beam during the operation period of the solar cell for space use.

In addition, in the solar cells 10 and 10a of the present embodiment, the proton beam shielding layer 13 is stacked on the photoelectric conversion portion 12 by applying a semiconductor thin film forming process. In the present embodiment, the proton beam shielding layer 13 having an excellent proton beam shielding capability can be formed to be lighter than the cover glass, and a complicated assembly step such as bonding of the cover glass can be omitted. Accordingly, the solar cells 10 and 10a of the present embodiment are lightweight and excellent in cost as compared with a solar cell having a cover glass.

<Description of Examples>

Hereinafter, examples of the solar cell of the present embodiment will be described.

(Example 1)

In Example 1, four solar cells having different thin films formed on a transparent electrode layer were compared, and the differences in product of the electron density and the film thickness and emissivity of the thin film were calculated by simulation. The configuration from the conductive substrate to the transparent electrode layer of the solar cell of Example 1 is a CIS solar cell. The configuration of the solar cell of Example 1 is described below.

- Comparative Example 1: A solar cell without a thin film on a transparent electrode layer
- Example 1A: A solar cell having a $ZrO_2$ thin film of 4.59 um formed on a transparent electrode layer
- Example 1B: A solar cell in which a $ZrO_2$ thin film of 4.59 um and a $SiO_2$ thin film of 1.3 um are stacked and formed in order from the bottom on a transparent electrode layer
- Example 1C: A solar cell in which a $ZrO_2$ thin film of 4.59 um, an $Al_2O_3$ thin film of 0.65 um, and a $SiO_2$ thin film of 0.65 um are stacked and formed in order from the bottom on a transparent electrode layer

The product of the film thickness and the electron density of the thin film in the case of shielding a proton beam of 0.6 MeV was smaller than $5 \times 10^{20}$ (cm$^{-2}$) in Comparative Example 1, and was $5 \times 10^{20}$ (cm$^{-2}$) or more in Example 1A, Example 1B, and Example 1C.

In addition, the emissivity in Comparative Example 1 was 31.3%, and the emissivity in Example 1A was 75.7%. On the other hand, the emissivity in Example 1B was 80.6%, and the emissivity in Example 1C was 83.7%. Accordingly, in the configuration in which two or more proton beam shielding layers were stacked as in Examples 1B and 1C, the emissivity was improved as compared with Comparative Example 1 and Example 1A. In addition, as in Example 1C with respect to Example 1B, in the configuration in which the proton beam shielding layers of different materials were stacked even if the total film thicknesses of the second and subsequent proton beam shielding layers were the same, the emissivity was improved as compared with Example 1B.

In addition, $Al_2O_3$, which is the thin film material of Example 1C, is also the material of the heat emission layer. Therefore, Example 1C can also be considered to have a configuration including a heat emission layer in which an $Al_2O_3$ thin film and a $SiO_2$ thin film are stacked. That is, it is also found that the formation of the heat emission layer having a stacked structure of $Al_2O_3$ and $SiO_2$ contributes to the improvement of the emissivity as compared with the case where

a single-layer $SiO_2$ thin film is formed as the heat emission layer on the proton beam shielding layer.

(Example 2)

The energy for shielding the proton beam is calculated from the range. Thus, in Example 2, each film thickness in the case of a thin film including a plurality of materials was calculated by simulation.

In Example 2, the film thickness when shielding energies of 0.6 MeV and 1 MeV with respect to a material Z (mixed composition) including $Al_2O_3$, $Y_2O_3$, and $In_2O_3$ at a ratio of 1 : 1 : 1 was calculated. Table 2 indicates a calculation result in Example 2.

[Table 2]

|  | Film thickness ($\mu$m) blocking 0.6 MeV | Film thickness ($\mu$m) blocking 1 MeV |
|---|---|---|
| Material Z | 4.8 | 10.01 |

In this way, by the combination of the material and the film thickness indicated in Example 2, it is theoretically possible to provide a solar cell capable of shielding the energy of a proton beam of 0.6 MeV.

(Example 3)

In Example 3, the film thicknesses when the stacked films formed by stacking an $Al_2O_3$ thin film, a $Y_2O_3$ thin film, and an $In_2O_3$ thin film with the same film thickness shielded the energies of 0.6 MeV and 1 MeV were calculated. Table 3 indicates a calculation result in Example 3. Note that the film thickness of each of the $Al_2O_3$ thin film, the $Y_2O_3$ thin film, and the $In_2O_3$ thin film is 1/3 of the film thickness of the stacked films.

[Table 3]

|  | Film thickness ($\mu$m) blocking 0.6 MeV | Film thickness ($\mu$m) blocking 1 MeV |
|---|---|---|
| Stacked film ($Al_2O_3$/$Y_2O_3$/$In_2O_3$) | 4.5 | 9.6 |

In this way, by the stacked films indicated in Example 3, it is theoretically possible to provide a solar cell capable of shielding the energy of a proton beam of 0.6 MeV.

(Example 4)

In Example 4, the emissivities in a case where a thin film of $SiO_2$ or $Al_2O_3$ was formed as a heat emission layer on a proton beam shielding layer stacked on a CIS-based solar cell and in a case where an $In_2O_3$ thin film was formed as a comparative example were calculated by simulation. As a material of the proton beam shielding layer in Example 4, $Al_2O_3$, $HfO_2$, $In_2O_3$, $ZrO_2$, and $Y_2O_3$ were selected. Then, the film thickness of the proton beam shielding layer was set to the minimum film thickness capable of shielding a proton beam of 0.6 MeV for each material, and the film thickness of the thin film on the proton beam shielding layer was set to 1.0 um. Table 4 indicates calculation results in Example 4.

[Table 4]

| Material of proton beam shielding layer | Rate of emissivity when thin film of each material is stacked on proton beam shielding layer with emissivity of proton beam shielding layer alone defined as 1 | | |
|---|---|---|---|
|  | $SiO_2$ | $Al_2O_3$ | $In_2O_3$ (Comparative example) |
| $Al_2O_3$ | 1.06 | 1.02 | 0.35 |
| $HfO_2$ | 1.22 | 1.41 | 0.64 |
| $In_2O_3$ | 1.90 | 1.93 | 1.00 |
| $ZrO_2$ | 1.06 | 1.05 | 0.35 |
| $Y_2O_3$ | 1.11 | 1.03 | 0.36 |

Table 4 indicates the rates of the emissivity when the thin film is stacked on the proton beam shielding layer with the emissivity of the proton beam shielding layer alone defined as 1. As indicated in Table 4, it can be seen that when a thin film of $SiO_2$ or $Al_2O_3$ is formed on the proton beam shielding layer, the rate of the emissivity is 1 or more, and the emissivity is improved by the heat emission layer. Specifically, it is considered that reflection of light having a wavelength range of 5 um to 15 um is suppressed by the thin film of $SiO_2$ or $Al_2O_3$, so that the emissivity is improved as described above. On the other hand, when an $In_2O_3$ thin film is formed on the proton beam shielding layer of the comparative example, the emissivity tends to decrease due to an increase in light reflectance.

(Example 5)

In Example 5, the emissivities in a case where a thin film of $SiO_2$ or $Al_2O_3$ was formed as a heat emission layer on a proton beam shielding layer stacked on a solar cell using crystalline Si-based semiconductor substrate and in a case where an $In_2O_3$ thin film was formed as a comparative example were calculated by simulation. As a material of the proton beam shielding layer in Example 5, $ZrO_2$ was selected. Then, the film thickness of the proton beam shielding layer was set to the minimum film thickness capable of shielding a proton beam of 0.6 MeV, and the film thickness of the thin film on the proton beam shielding layer was set to 1.0 um. Table 5 indicates calculation results in Example 5.

[Table 5]

| Material of proton beam shielding layer | Rate of emissivity when thin film of each material is stacked on proton beam shielding layer with emissivity of proton beam shielding layer alone defined as 1 | | |
|---|---|---|---|
| | $SiO_2$ | $Al_2O_3$ | $In_2O_3$ (Comparative example) |
| $ZrO_2$ | 1.01 | 1.03 | 0.32 |

Similarly to Table 4, Table 5 indicates the rates of the emissivity when the thin film is stacked on the proton beam shielding layer with the emissivity of the proton beam shielding layer alone defined as 1. As indicated in Table 5, it can be seen that when a thin film of $SiO_2$ or $Al_2O_3$ is formed on the proton beam shielding layer, the rate of the emissivity is 1 or more, and the emissivity is improved by the heat emission layer. Specifically, it is considered that reflection of light having a wavelength range of 5 um to 15 um is suppressed by the thin film of $SiO_2$ or $Al_2O_3$, so that the emissivity is improved as described above. On the other hand, when an $In_2O_3$ thin film is formed on the proton beam shielding layer of the comparative example, the emissivity tends to decrease due to an increase in light reflectance.

According to Examples 4 and 5 described above, it can be seen that the emissivity can be improved by forming a thin film of 1.0 um formed of $SiO_2$ or $Al_2O_3$ as a heat emission layer on a proton beam shielding layer having a film thickness capable of shielding a proton beam of 0.6 MeV in any of a CIS-based solar cell and a solar cell using a crystalline Si-based semiconductor substrate.

(Example 6)

In Example 6, in a case where a thin film of $SiO_2$ or $Al_2O_3$ is formed as a heat emission layer on a proton beam shielding layer, a film thickness for achieving an emissivity of 80% or more was calculated by simulation. Note that the configuration from the conductive substrate to the transparent electrode layer of the solar cell of Example 6 is a CIS solar cell.

As a material of the proton beam shielding layer in Example 6, $Al_2O_3$, $HfO_2$, $In_2O_3$, $ZrO_2$, and $Y_2O_3$ were selected. Then, the film thickness of the proton beam shielding layer was set to the minimum film thickness capable of shielding a proton beam of 0.6 MeV for each material. Table 6 indicates calculation results in Example 6.

[Table 6]

| Material of proton beam shielding layer | Film thickness (nm) necessary for achieving emissivity of 80% or more | |
|---|---|---|
| | In case of $SiO_2$ alone | In case of $Al_2O_3$ alone |
| $Al_2O_3$ | 300 | 2830 |
| $HfO_2$ | 10430 | 7050 |
| $In_2O_3$ | 21250 | 8230 |

(continued)

| Material of proton beam shielding layer | Film thickness (nm) necessary for achieving emissivity of 80% or more | |
| --- | --- | --- |
| | In case of SiO$_2$ alone | In case of Al$_2$O$_3$ alone |
| ZrO$_2$ | 360 | 3270 |
| Y$_2$O$_3$ | 210 | 4020 |

As indicated in Table 6, when a thin film of SiO$_2$ or Al$_2$O$_3$ is formed on a proton beam emission layer, it is found that it is necessary to set at least the film thickness to 210 nm or more in order to achieve an emissivity of 80% or more.

(Example 7)

In Example 7, in a case where a SiO$_2$ thin film and an Al$_2$O$_3$ thin film are stacked and formed on a proton beam shielding layer, each film thickness for achieving an emissivity of 80% or more was calculated by simulation. Note that the configuration from the conductive substrate to the transparent electrode layer of the solar cell of Example 7 is a CIS solar cell.

In Example 7, the Al$_2$O$_3$ thin film and the SiO$_2$ thin film are configured to be sequentially stacked on the proton beam shielding layer. In addition, as a material of the proton beam shielding layer, Al$_2$O$_3$, HfO$_2$, In$_2$O$_3$, ZrO$_2$, and Y$_2$O$_2$ were selected. Then, the film thickness of the proton beam shielding layer was set to the minimum film thickness capable of shielding a proton beam of 0.6 MeV for each material.

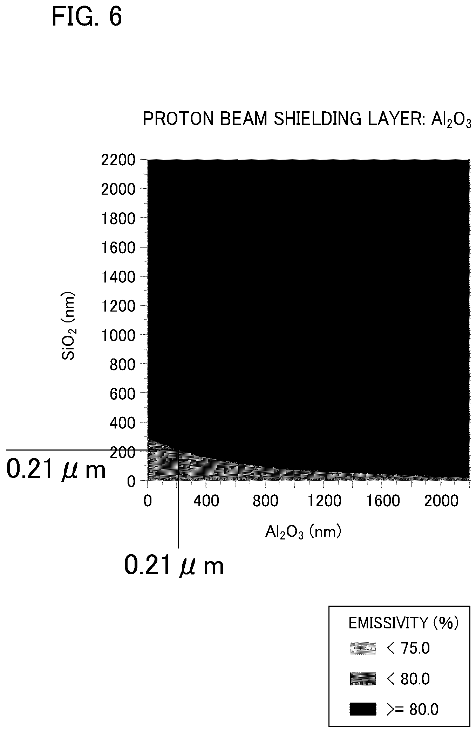

Figs. 6 to 10 illustrate simulation results of Example 7. The vertical axis in each drawing of Figs. 6 to 10 is the film thickness (nm) of the SiO$_2$ thin film, and the horizontal axis in each drawing of Figs. 6 to 10 is the film thickness (nm) of the Al$_2$O$_3$ thin film. In addition, in each drawing of Figs. 6 to 10, distributions of a region having an emissivity of less than 75%, a region having an emissivity of 75% or more and less than 80%, and a region having an emissivity of 80% or more are illustrated.

Fig. 6 is a distribution diagram illustrating the relationship between the film thicknesses of the Al$_2$O$_3$ thin film and the SiO$_2$ thin film when the material of the proton beam shielding layer is Al$_2$O$_3$. In the case of Fig. 6, when both the film thickness of the Al$_2$O$_3$ thin film and the film thickness of the SiO$_2$ thin film are 0.21 $\mu$m, a region having an emissivity of 80% or more is recognized. In addition, an example of a combination of film thicknesses of Al$_2$O$_3$ and SiO$_2$ of the heat emission layer when the proton beam shielding layer is Al$_2$O$_3$ and the emissivity is 80% is indicated in Table 7.

[Table 7]

| Point | Al$_2$O$_3$ (nm) | SiO$_2$ (nm) |
| --- | --- | --- |
| 1 | 0 | 300 |
| 2 | 100 | 250 |
| 3 | 240 | 200 |
| 4 | 420 | 150 |
| 5 | 720 | 100 |
| 6 | 1020 | 70 |
| 7 | 1340 | 50 |
| 8 | 1820 | 30 |
| 9 | 2830 | 0 |

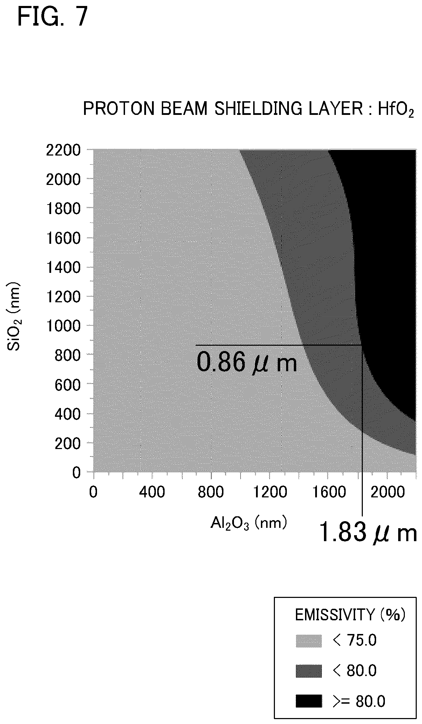

Fig. 7 is a distribution diagram illustrating the relationship between the film thicknesses of the Al$_2$O$_3$ thin film and the SiO$_2$ thin film when the material of the proton beam shielding layer is HfO$_2$. In the case of Fig. 7, when the film thickness of the Al$_2$O$_3$ thin film is 1.83 um and the film thickness of the SiO$_2$ thin film is 0.86 $\mu$m, a region having an emissivity of 80% or more is recognized. In addition, an example of a combination of film thicknesses of Al$_2$O$_3$ and SiO$_2$ of the heat emission layer when the proton beam shielding layer is HfO$_2$ and the emissivity is 80% is indicated in Table 8.

[Table 8]

| Point | Al$_2$O$_3$ (nm) | SiO$_2$ (nm) |
|---|---|---|
| 1 | 1130 | 2990 |
| 2 | 1590 | 2210 |
| 3 | 1700 | 2000 |
| 4 | 1760 | 1700 |
| 5 | 1780 | 1510 |
| 6 | 1810 | 990 |
| 7 | 1850 | 810 |
| 8 | 1900 | 660 |
| 9 | 1980 | 540 |
| 10 | 2110 | 410 |
| 11 | 2290 | 310 |
| 12 | 2490 | 230 |
| 13 | 2750 | 180 |
| 14 | 2930 | 160 |
| 15 | 2990 | 150 |

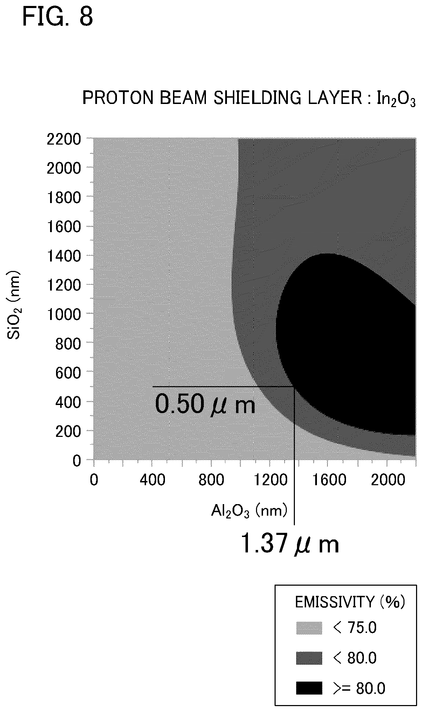

Fig. 8 is a distribution diagram illustrating the relationship between the film thicknesses of the Al$_2$O$_3$ thin film and the SiO$_2$ thin film when the material of the proton beam shielding layer is In$_2$O$_3$. In the case of Fig. 8, when the film thickness of the Al$_2$O$_3$ thin film is 1.37 um and the film thickness of the SiO$_2$ thin film is 0.50 um, a region having an emissivity of 80% or more is recognized. In addition, an example of a combination of film thicknesses of Al$_2$O$_3$ and SiO$_2$ of the heat emission layer when the proton beam shielding layer is In$_2$O$_3$ and the emissivity is 80% is indicated in Table 9.

[Table 9]

| Point | Al$_2$O$_3$ (nm) | SiO$_2$ (nm) |
|---|---|---|
| 1 | 1250 | 800 |
| 2 | 1250 | 980 |
| 3 | 1280 | 1100 |
| 4 | 1290 | 640 |
| 5 | 1330 | 1230 |
| 6 | 1380 | 1300 |
| 7 | 1390 | 470 |
| 8 | 1460 | 1360 |
| 9 | 1540 | 1390 |
| 10 | 1550 | 330 |
| 11 | 1610 | 1400 |
| 12 | 1680 | 1380 |
| 13 | 1690 | 250 |
| 14 | 1850 | 200 |
| 15 | 1870 | 1300 |

(continued)

| Point | Al$_2$O$_3$ (nm) | SiO$_2$ (nm) |
|---|---|---|
| 16 | 2040 | 170 |
| 17 | 2040 | 1180 |
| 18 | 2180 | 1060 |
| 19 | 2360 | 170 |
| 20 | 2390 | 860 |
| 21 | 2580 | 660 |
| 22 | 2600 | 230 |
| 23 | 2640 | 250 |
| 24 | 2680 | 510 |
| 25 | 2690 | 300 |
| 26 | 2700 | 470 |
| 27 | 2710 | 340 |
| 28 | 2710 | 440 |

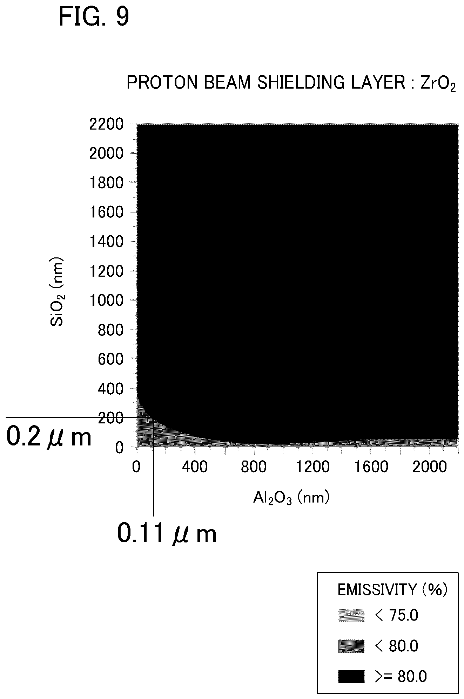

Fig. 9 is a distribution diagram illustrating the relationship between the film thicknesses of the Al$_2$O$_3$ thin film and the SiO$_2$ thin film when the material of the proton beam shielding layer is ZrO$_2$. In the case of Fig. 9, when the film thickness of the Al$_2$O$_3$ thin film is 0.11 um and the film thickness of the SiO$_2$ thin film is 0.2 um, a region having an emissivity of 80% or more is recognized. In addition, an example of a combination of film thicknesses of Al$_2$O$_3$ and SiO$_2$ of the heat emission layer when the proton beam shielding layer is ZrO$_2$ and the emissivity is 80% is indicated in Table 10.

[Table 10]

| Point | Al$_2$O$_3$ (nm) | SiO$_2$ (nm) |
|---|---|---|
| 1 | 0 | 360 |
| 2 | 110 | 200 |
| 3 | 320 | 90 |
| 4 | 740 | 20 |
| 5 | 1090 | 20 |
| 6 | 1600 | 50 |
| 7 | 2190 | 50 |
| 8 | 2850 | 20 |
| 9 | 2990 | 20 |

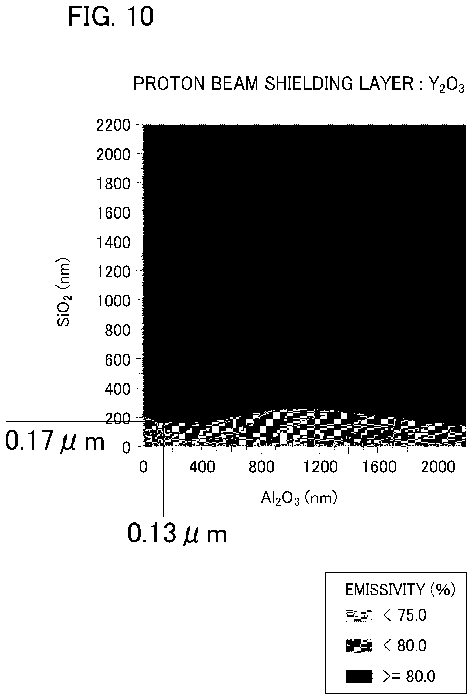

Fig. 10 is a distribution diagram illustrating the relationship between the film thicknesses of the Al$_2$O$_3$ thin film and the SiO$_2$ thin film when the material of the proton beam shielding layer is Y$_2$O$_3$. In the case of Fig. 10, when the film thickness of the Al$_2$O$_3$ thin film is 0.13 um and the film thickness of the SiO$_2$ thin film is 0.17 um, a region having an emissivity of 80% or more is recognized. In addition, an example of a combination of film thicknesses of Al$_2$O$_3$ and SiO$_2$ of the heat emission layer when the proton beam shielding layer is Y$_2$O$_3$ and the emissivity is 80% is indicated in Table 11.

[Table 11]

| Point | Al$_2$O$_3$ (nm) | SiO$_2$ (nm) |
|---|---|---|
| 1 | 0 | 210 |
| 2 | 80 | 180 |

(continued)

| Point | Al$_2$O$_3$ (nm) | SiO$_2$ (nm) |
|---|---|---|
| 3 | 230 | 160 |
| 4 | 330 | 160 |
| 5 | 510 | 180 |
| 6 | 850 | 240 |
| 7 | 1020 | 260 |
| 8 | 1320 | 240 |
| 9 | 1510 | 220 |
| 10 | 2100 | 150 |
| 11 | 2850 | 80 |
| 12 | 2990 | 80 |

As illustrated in Figs. 6 to 10, when the Al$_2$O$_3$ thin film and the SiO$_2$ thin film are sequentially stacked on the proton beam shielding layer, it is found that it is necessary to set at least any one of film thickness to 110 nm or more in order to achieve an emissivity of 80% or more.

<Supplementary Matters of the Embodiment>

In the above embodiment, the configuration examples of the solar cell including the proton beam shielding layer have been described as an example of the photoelectric conversion element for space use. However, the configuration of the photoelectric conversion element of the present invention is not limited to a solar cell, and can be widely applied to other semiconductor elements (for example, an imaging element or the like) that are used in outer space and include a photoelectric conversion layer.

In addition, the present invention is not limited to a CIS-based solar cell or a solar cell using a crystalline Si-based semiconductor substrate, and can also be applied to a compound-based solar cell other than a CIS-based solar cell or another general solar cell. As an example, the configuration of the present invention can also be applied to a compound-based solar cell such as a CZTS-based solar cell, a CIGS-based solar cell, a CdTe-based solar cell, or a GaAs-based solar cell, an organic solar cell, or the like.

In addition, the proton beam shielding layer or the heat emission layer of the present invention may be configured as stacked films of three or more layers.

As described above, the embodiment of the present invention has been described, but the embodiment is presented as an example, and is not intended to limit the scope of the present invention. The embodiment can be implemented in various forms other than the above, and various omissions, substitutions, changes, and the like can be made without departing from the gist of the present invention. The embodiment and modifications thereof are included in the scope and gist of the present invention, and the invention described in the claims and equivalents thereof are also included in the scope and gist of the present invention.

The present application claims priority based on Japanese Patent Application No. 2021-057856 filed on March 30, 2021, and the entire contents of Japanese Patent Application No. 2021-057856 are incorporated herein by reference.

Reference Signs List

10, 10a     Solar cell
11         Conductive substrate
11a       Semiconductor substrate
12         Photoelectric conversion portion
13         Proton beam shielding layer
14         Heat emission layer
21         First electrode layer
22         Photoelectric conversion layer

| 23 | Buffer layer |
|---|---|
| 24 | Second electrode layer |
| 31 | First electrode layer |
| 32 | Semiconductor layer |
| 33 | Second electrode layer |

**Claims**

1. A photoelectric conversion element comprising:

   a photoelectric conversion portion; and
   a proton beam shielding layer that is formed on the photoelectric conversion portion and shields the photoelectric conversion portion from a proton beam,
   wherein
   a product of an electron density and a film thickness of the proton beam shielding layer is $5 \times 10^{20}$ (cm$^{-2}$) or more.

2. The photoelectric conversion element according to claim 1, wherein the photoelectric conversion portion is formed on a substrate.

3. The photoelectric conversion element according to claim 1, wherein the photoelectric conversion portion includes a semiconductor substrate.

4. The photoelectric conversion element according to any one of claims 1 to 3, wherein the proton beam shielding layer is a layer including a first material selected from one or more of $Al_2O_3$, $Y_2O_3$, $ZrO_2$, $MgO$, $HfO_2$, $Bi_2O_3$, $TiO_2$, $ZnO$, $In_2O_3$, $SnO_2$, $Nb_2O_5$, and $Ta_2O_5$.

5. The photoelectric conversion element according to claim 4, wherein the proton beam shielding layer is stacked films in which layers including two or more types of the first material are stacked.

6. The photoelectric conversion element according to any one of claims 1 to 3, further comprising a heat emission layer formed on the proton beam shielding layer.

7. The photoelectric conversion element according to claim 6, wherein the heat emission layer is a layer including a second material selected from at least one of $SiO_2$ and $Al_2O_3$.

8. The photoelectric conversion element according to claim 7, wherein the heat emission layer has a thickness of 210 nm or more.

9. The photoelectric conversion element according to claim 8, wherein the heat emission layer is stacked films in which layers including two types of the second material are stacked.

10. The photoelectric conversion element according to claim 9, wherein a thickness of any one of film in stacked films of the heat emission layer is 110 nm or more.

11. A method for manufacturing a photoelectric conversion element including

    a photoelectric conversion portion, and
    a proton beam shielding layer that is formed on the photoelectric conversion portion and shields the photoelectric conversion portion from a proton beam,
    the method comprising:

    a step of forming the photoelectric conversion portion; and
    a step of forming the proton beam shielding layer having a product of an electron density and a film thickness of $5 \times 10^{20}$ (cm$^{-2}$) or more on the photoelectric conversion portion.

12. The method for manufacturing a photoelectric conversion element according to claim 11, further comprising a step of forming a heat emission layer on the proton beam shielding layer.

FIG. 1

FIG. 2

LIGHT

10a

| 14 | |
| 13 | |
| 33 | |
| 32 | 12 |
| 11a | |
| 31 | |

# FIG. 3

LOW-ENERGY
PROTON BEAM

(a)

| TRANSPARENT ELECTRODE LAYER |
| P/N JUNCTION PORTION (P+) |
| SUBSTRATE OR THE LIKE |

LOW-ENERGY
PROTON BEAM

(b)

| (P+) |
| COVER GLASS |
| TRANSPARENT ELECTRODE LAYER |
| P/N JUNCTION PORTION (P+) |
| SUBSTRATE OR THE LIKE |

HIGH-ENERGY
PROTON BEAM

FIG. 4

| Energy (MeV) of proton beam | 0.5 | 0.6 | 0.7 | 0.8 | 0.9 | 1 | 2 | 3 | 6 |
|---|---|---|---|---|---|---|---|---|---|
| fluence $(cm^{-2})$ corresponding to operation period | 1.5E+10 | 1.0E+10 | 8.6E+09 | 7.7E+09 | 6.9E+09 | 5.1E+09 | 3.4E+09 | 3.4E+09 | 2.6E+09 |

## FIG. 5

| Material | Electron density ($cm^{-3}$) | Film thickness ($\mu$m) shielding proton beam of 0.6 MeV (µm) | Film thickness ($\mu$m) shielding proton beam of 1MeV | Film thickness × electron density ($cm^{-2}$) shielding proton beam of 0.6 MeV | Film thickness × electron density ($cm^{-2}$) shielding proton beam of 1 MeV |
|---|---|---|---|---|---|
| $SiO_2$ | 7.98E+23 | 7.62 | 16.17 | 6.08E+20 | 1.29E+21 |
| $MgF_2$ | 9.48E+23 | 5.84 | 12.08 | 5.54E+20 | 1.15E+21 |
| MgO | 1.07E+24 | 4.68 | 9.86 | 5.00E+20 | 1.06E+21 |
| $Al_2O_3$ | 1.17E+24 | 4.37 | 9.20 | 5.10E+20 | 1.07E+21 |
| $TiO_2$ | 1.21E+24 | 4.55 | 9.67 | 5.51E+20 | 1.17E+21 |
| $Nb_2O_5$ | 1.27E+24 | 5.24 | 11.12 | 6.67E+20 | 1.41E+21 |
| $Y_2O_3$ | 1.37E+24 | 5.26 | 11.08 | 7.23E+20 | 1.52E+21 |
| $ZrO_2$ | 1.56E+24 | 4.59 | 9.64 | 7.16E+20 | 1.50E+21 |
| ZnO | 1.58E+24 | 4.69 | 9.49 | 7.38E+20 | 1.49E+21 |
| $In_2O_3$ | 1.90E+24 | 4.31 | 8.86 | 8.19E+20 | 1.68E+21 |
| $Ta_2O_5$ | 2.08E+24 | 4.84 | 9.72 | 1.01E+21 | 2.02E+21 |
| $HfO_2$ | 2.44E+24 | 4.32 | 8.60 | 1.06E+21 | 2.10E+21 |

EP 4 318 603 A1

FIG. 6

PROTON BEAM SHIELDING LAYER: $Al_2O_3$

0.21 $\mu$ m

0.21 $\mu$ m

$Al_2O_3$ (nm)

$SiO_2$ (nm)

EMISSIVITY (%)

< 75.0

< 80.0

>= 80.0

# FIG. 7

PROTON BEAM SHIELDING LAYER : $HfO_2$

EMISSIVITY (%)
< 75.0
< 80.0
>= 80.0

## FIG. 8

PROTON BEAM SHIELDING LAYER : $In_2O_3$

0.50 $\mu$ m

1.37 $\mu$ m

EMISSIVITY (%)

$<$ 75.0

$<$ 80.0

$>=$ 80.0

# FIG. 9

PROTON BEAM SHIELDING LAYER : $ZrO_2$

EMISSIVITY (%)

| | |
|---|---|
| ▨ | $< 75.0$ |
| ▨ | $< 80.0$ |
| ■ | $>= 80.0$ |

FIG. 10

PROTON BEAM SHIELDING LAYER : $Y_2O_3$

$0.17 \mu m$

$0.13 \mu m$

EMISSIVITY (%)
< 75.0
< 80.0
>= 80.0

## INTERNATIONAL SEARCH REPORT

| International application No. |
|---|
| **PCT/JP2022/015546** |

**A. CLASSIFICATION OF SUBJECT MATTER**

*H01L 31/041*(2014.01)i; *H01L 31/0216*(2014.01)i
FI: H01L31/04 220; H01L31/04 240

According to International Patent Classification (IPC) or to both national classification and IPC

**B. FIELDS SEARCHED**

Minimum documentation searched (classification system followed by classification symbols)

H01L31/00-31/078; H01L31/18-31/20; H01L51/42-51/48; H02S10/00-10/40; H02S30/00-99/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2017-525324 A (CALIFORNIA INSTITUTE OF TECHNOLOGY) 31 August 2017 (2017-08-31) entire text, all drawings | 1-12 |
| A | JP 7-58355 A (OPTICAL COATING LABORATORY INC) 03 March 1995 (1995-03-03) entire text, all drawings | 1-12 |
| A | JP 2014-16348 A (QIOPTIQ LTD) 30 January 2014 (2014-01-30) entire text, all drawings | 1-12 |
| A | JP 2006-310711 A (JAPAN AEROSPACE EXPLORATION AGENCY) 09 November 2006 (2006-11-09) entire text, all drawings | 1-12 |
| A | JP 2004-504232 A (UNIVERSITE DE LIEGE) 12 February 2004 (2004-02-12) entire text, all drawings | 1-12 |
| A | JP 5-82822 A (NIPPON ELECTRIC GLASS CO LTD) 02 April 1993 (1993-04-02) entire text, all drawings | 1-12 |

✓ Further documents are listed in the continuation of Box C.    ✓ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 April 2022** | **10 May 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2022/015546**

**C.    DOCUMENTS CONSIDERED TO BE RELEVANT**

| Category* | Citation of document, with indication, where appropriate, of the relevant passages | Relevant to claim No. |
|---|---|---|
| A | US 2017/0054048 A1 (SOLAERO TECHNOLOGIES CORP.) 23 February 2017 (2017-02-23)<br>entire text, all drawings | 1-12 |

Form PCT/ISA/210 (second sheet) (January 2015)

## INTERNATIONAL SEARCH REPORT
### Information on patent family members

International application No.

**PCT/JP2022/015546**

| Patent document cited in search report | | | Publication date (day/month/year) | Patent family member(s) | | | Publication date (day/month/year) |
|---|---|---|---|---|---|---|---|
| JP | 2017-525324 | A | 31 August 2017 | US | 2016/0056321 | A1 | |
| | | | | entire text, all drawings | | | |
| JP | 7-58355 | A | 03 March 1995 | US | 5449413 | A | |
| | | | | entire text, all drawings | | | |
| JP | 2014-16348 | A | 30 January 2014 | US | 2014/0007924 | A1 | |
| | | | | entire text, all drawings | | | |
| JP | 2006-310711 | A | 09 November 2006 | US | 2006/0243320 | A1 | |
| | | | | entire text, all drawings | | | |
| JP | 2004-504232 | A | 12 February 2004 | US | 2002/0007845 | A1 | |
| | | | | entire text, all drawings | | | |
| JP | 5-82822 | A | 02 April 1993 | (Family: none) | | | |
| US | 2017/0054048 | A1 | 23 February 2017 | CN | 110047954 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4565105 B

- JP 2021057856 A

**Non-patent literature cited in the description**

- **SUMIO MATSUDA.** Coverglasses protected solar cells from cosmic rays. *New GLASS,* 1999, vol. 14 (4), 27-30